# EUROPEAN PATENT SPECIFICATION

(11) **EP 3 418 506 B1**
(45) Date of publication and mention of the grant of the patent: **28.01.2026**
(21) Application number: 18178001.6
(22) Date of filing: 15.06.2018
(51) Int. Cl.: F01D 25/16, F16C 32/04

(54) **TURBOMACHINE CONTROL SYSTEM FOR HAZARDOUS AREAS**
TURBOMASCHINENSTEUERUNGSSYSTEM FÜR GEFAHRENBEREICHE
SYSTÈME DE COMMANDE DE TURBOMACHINE DESTINÉS À DES ZONES DANGEREUSES

(30) Priority: 19.06.2017 IT 201700067928
(43) Date of publication of application: 26.12.2018
(73) Proprietor: Nuovo Pignone Tecnologie - S.r.l., 50127 Florence (IT)
(72) Inventor: LOTTI, Claudio, 50127 Florence (IT); GIREZZI, Daniele, 50127 Florence (IT); SANGIOVANNI, Roberto, 50127 Florence (IT); ORTIZ NERI, Massimiliano, 50127 Florence (IT)
(74) Representative: Novagraaf Group

(56) References cited:
- EP-A2- 0 208 129
- EP-A2- 0 261 307
- WO-A1-2016/087303
- WO-A1-2016/096545
- DE-A1- 102008 031 994

## Description

### BACKGROUND

The present disclosure relates to turbomachines. Embodiments disclosed herein specifically relate to compressors, turbines, turbocompressors, motor, generators, turbogenerator, expander-generator. More specifically, the disclosure relates to improvements to motor-compressor and expander-compressor units comprising one or more magnetic bearings supporting the driving shaft, which connects the motor/expander to the compressor.

Motor-compressor units are usually comprised of one or two outer casings which house an electric motor and a compressor, connected to one another by a driving shaft. The shaft is supported by a plurality of bearings. In some integrated applications the casing is a pressure casing comprising a motor compartment, which houses the electric motor, and a compressor compartment, which houses the compressor.

WO 2016/087303 Al discloses an electronic control system which provides power and control signals to magnetic bearings housed in a control system compartment formed inside an axiliary casing portion forming part of a pressure casing.

Turboexpander units are commonly used machines for converting the power contained in a flow of compressed gas into useful mechanical power available on an output shaft of the turboexpander. The output shaft can be used to mechanically drive a rotating machine, for example a compressor or an electric generator. Integrated turboexpander units usually comprise a gas tight casing housing a turboexpander with a rotating wheel or a plurality of rotating wheels, provided with blades, mounted on a rotating shaft. The shaft is supported for rotation in the casing and is mechanically connected to the rotor of a compressor or an electric generator, the stator whereof is stationarily mounted in the casing.

The rotating shaft of these turbomachines is usually supported in the casing by means of a plurality of bearings. In earlier units oil lubricated bearings were used for this purpose. More recently, active magnetic bearings (hereinafter referred to also as AMBs) have been developed. AMBs avoid the need of lubricating oil and therefore overcome drawbacks related to the presence of oil in the gas flow through the unit.

AMBs are controlled by an electronic control system. The electronic control system must be connected to the magnetic bearings housed in the machine casing, therefore a cable connection electrically connects the control system with the interior of the machine casing.

The turbomachinery working with compressed gas are normally located in sites classified as hazardous due to the risk of explosion associated with the presence of flammable gas or vapour. The AMB control system is placed externally of the machine casing, in a safe area outside of the classified area, and at a variable distance therefrom up to several hundreds of meters. Junction boxes are commonly used to act as a separation element between the turbomachine and the control system. On the turbomachine side of the junction box there are the cables connected to the turbomachine, on the control side of the junction box there are the cables connected to the control system. In case of pressurized machines, the cables on the turbomachine side of the junction box pass through a protection system able to withstand the differential pressure between the turbomachine room and the external environment, while no special requirement is necessary for the cables of the control system side, apart from the necessity to increase their cross section depending on the length to avoid power loss.

The use of a relatively large number of long cables renders these known systems expensive and cumbersome. Furthermore, known systems require some on-site tuning activities due to different cable length and section between the cables employed for the factory test and set-up and the cables installed on-site. Improvements relating to the arrangement of the control system of the active magnetic bearings in a turbomachine unit would thus be desirable.

### BRIEF DESCRIPTION OF THE INVENTION

The present invention is defiined in the accompanying claims.

According to an exemplary embodiments, a turbomachine is described comprising a casing, a turbomachinery having a rotor mounted on a shaft coupled with a plurality of AMBs and supported for rotation in the casing. The AMBs are managed by an AMB control system connected through a plurality of cables and wires and housed in a control system compartment external to the casing and located in proximity thereto.

The cables connecting the AMBs to the AMBs control system are therefore much shorter than usual and have a much smaller cross section, moreover no junction box is required with an improvement in terms of compactness, reliability and cost reduction.

Advantageously, the control system compartment comprise a cabinet that can be either pressurized, or explosion proof or both. Explosion proof cabinet allows AMB control systems which are not designed for classified hazardous areas to be employed. Pressurization of the cabinet of the control system compartment saves the electronics inside from possible contamination with the process gas of the turbomachine.

The AMBs control system can be managed from remote and therefore the operator does not need to work in the classified area where the turbomachinery and the AMBs control system are located.

If the magnetic bearings control system is designed to work in classified hazardous areas, it can be placed directly in close proximity of the turbomachine without the need of an explosion proof container.

The control system compartment can host one or more electric and electronic components. In some embodiments such components are configured and arranged to control and power the magnetic bearings which support the shaft of the turbomachinery. In some embodiments the control system is an integrated control system comprising a section for the control of the magnetic bearings and a further section for the control of the turbomachinery.

### BRIEF DESCRIPTION OF THE DRAWINGS

The exemplary embodiments described herein will become more apparent when considered in conjunction with the accompanying drawings wherein:
Figure 1 illustrates a turbomachine - namely an expander-compressor unit - connected to an AMB control system according to the prior art;
Figure 2 illustrates a turbomachine according to embodiments described herein;
Figure 3 illustrates an integrated control system according to embodiments described herein;
Figure 4 illustrates the network topology of the control system of the integrated control system depicted in Figure 3;
Figure 5 illustrates an AMB control system separated from the unit control system according to embodiments described herein; and
Figure 6 illustrates the network topology of the control system depicted in Figure 5.

### DETAILED DESCRIPTION OF THE INVENTION

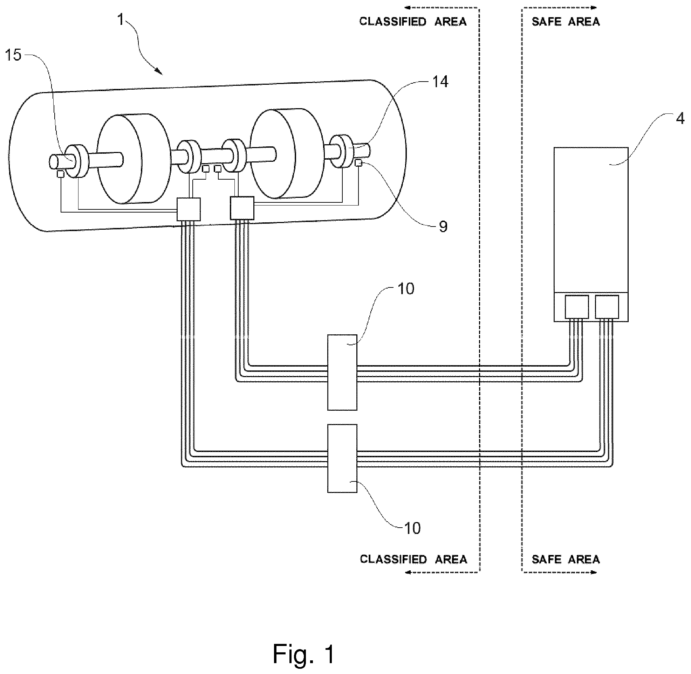

Figure 1 shows an exemplary turbomachine 1 - namely an expander-compressor unit - connected to an AMB control system according to the prior art.

As the AMB control system is located in a control system compartment 4 far away from the turbomachine, intermediate junction boxes 10 are used. These junction boxes act as separation elements between the turbomachine 1 and the AMB control system.

The junction boxes 10, one for the power cables and one for the signal cables, are installed in the classified area where the turbomachine is installed, not far from the turbomachine. Typically the junction boxes 10 can be installed on the skid supporting the turbomachine or in its vicinity, while the AMB control system is installed in a control system compartment 4 located in a safe area at a distance which can measure up to several hundreds of meters and is typically in the range 100m to 700m.

The cable size from junction boxes 10 to AMB control system depends on the distance between the field and the control system compartment 4. Longer the distance, larger is the required power cable cross section to reduce power loss.

On the turbomachine side, in typical applications, power cables and signal cables have, respectively, less than 10 mm2 and 1 mm2 cross section due to short distance. Larger cross sections are obviously possible.

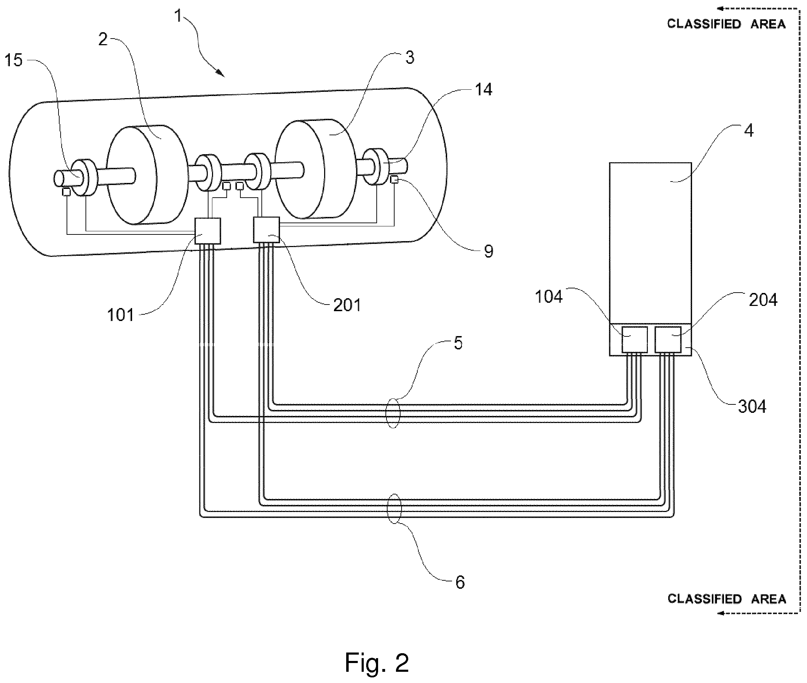

Fig. 2 exemplary shows a turbomachine according to embodiments herein. The turbomachine 1 comprises a casing, an expander 2 having a rotor mounted on a shaft 15 supported for rotation in the casing, a compressor 3 arranged in the casing and comprised of a rotor mounted on the shaft for co-rotation with the turbo-expander rotor.

The shaft 15 is supported in the casing by means of a plurality of bearings. In some embodiments a first radial bearing can be arranged at a first end of shaft 15. A second radial bearing can be provided at a second end of the shaft 15. In some embodiments one or more axial bearings can further be provided. A different number of magnetic bearings can be foreseen, e.g. depending upon design choices and/or requirements of the expander-compressor unit. More variability in the number of bearings, and thus of the cables, can be found in motor-compressor units which are part of the present disclosure.

One, some or all said bearings can be magnetic bearings and more specifically AMBs 14. AMBs 14 are known to those skilled in the art and will not be described in greater detail herein.

AMBs 14 require an electronic control system 7, which provides power and control signals to the magnetic bearings. According to embodiments disclosed herein the AMB control system 7 is housed in a control system compartment 4 external to the casing and located in proximity thereto. In some embodiments, the control system compartment 4 is pressurized to guarantee that the electronics inside is safe from possible contamination with the process gas of the turbomachine. In an embodiment the control system compartment 4 is located at a distance typically not greater than 20 m from the casing of the turbomachine 1.

The control system compartment 4 may house only the AMB control system 7 or an integrated control system comprising the AMB control system 7 and the turbomachinery unit control system 8 (UCS).

A turbomachinery control system 8 is based on PLC hardware and typically comprises a main controller 108 and a safety controller 208. The main controller 108 implements the machine start/stop sequence inclusive of all auxiliaries, antisurge control, performance control and load sharing control, while the safety controller 208 implements trip logics and other safety functions.

The unit control system 8 is generally hosted in a control cabinet with front door opening located in a safe area far away from the turbomachine. The operator interface is usually a PC with touchscreen panel located in the cabinet (HMI 121) or remotely connected (DCS 122) through a firewall 123 preferably provided with redundant connection.

In existing systems, the unit control system and the AMB control system 7 are independent and located in a safe area.

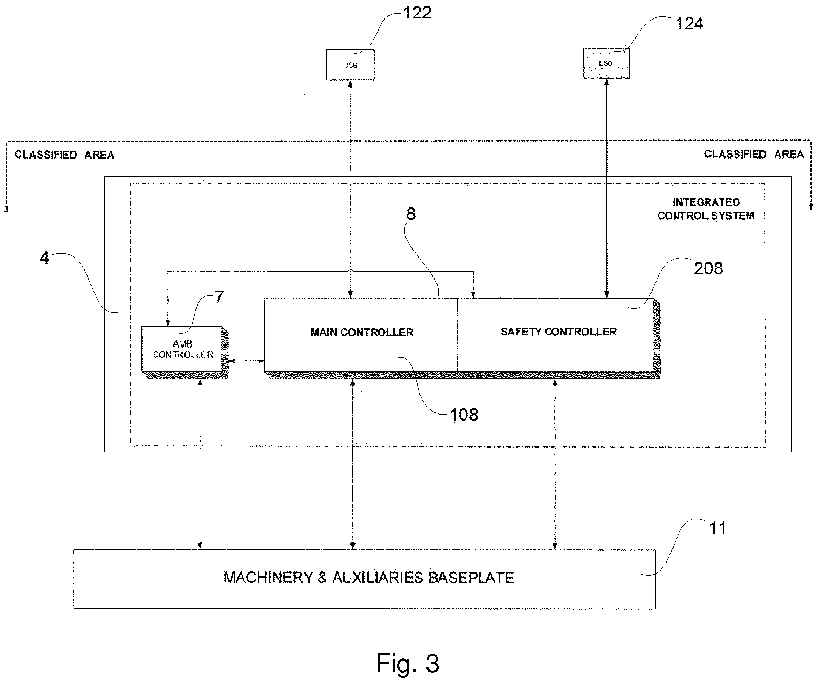

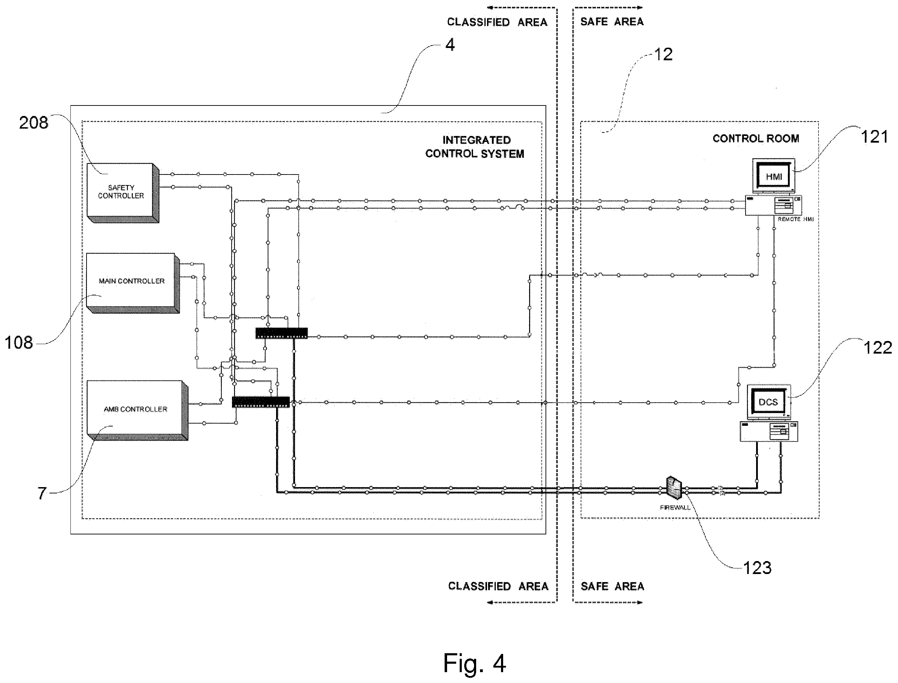

Fig. 3 shows an integrated control system according to embodiments herein. In this configuration, the AMB control system 7, the main controller 108 and the safety controller 208 are all hosted in a control system compartment 4 comprising an explosion proof cabinet and located in a classified hazardous area close to the machinery & auxiliary baseplate 11, while the user interface 121 (HMI) is positioned in a remote control room 12 located in a safe area as best shown in Fig. 4.

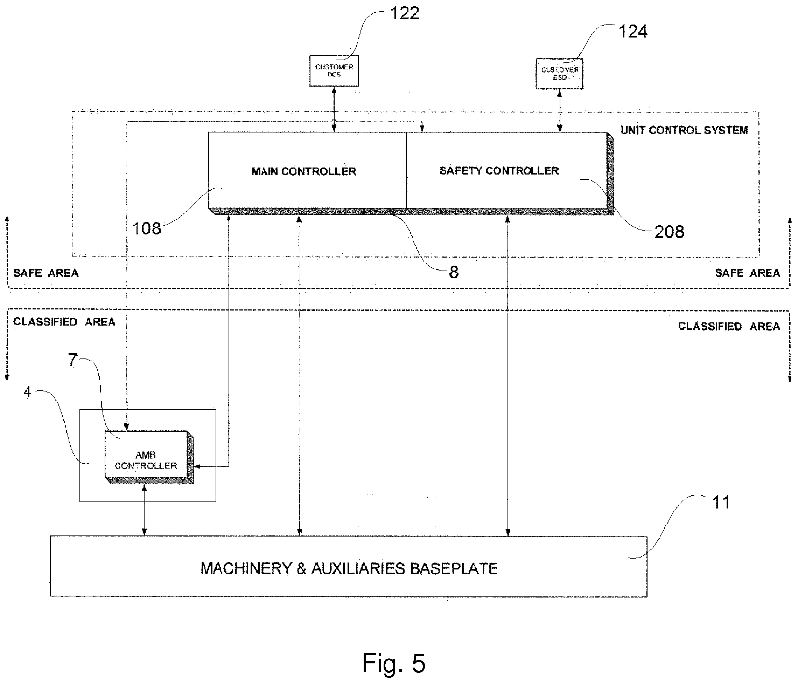

Fig. 5 shows a control system according to a further embodiment wherein the AMB control system 7 and the unit control system 8 are separate units. Like in existing systems, the main controller 108 and the safety controller 208 are located in a safe area 13 remote from the turbomachinery 2.

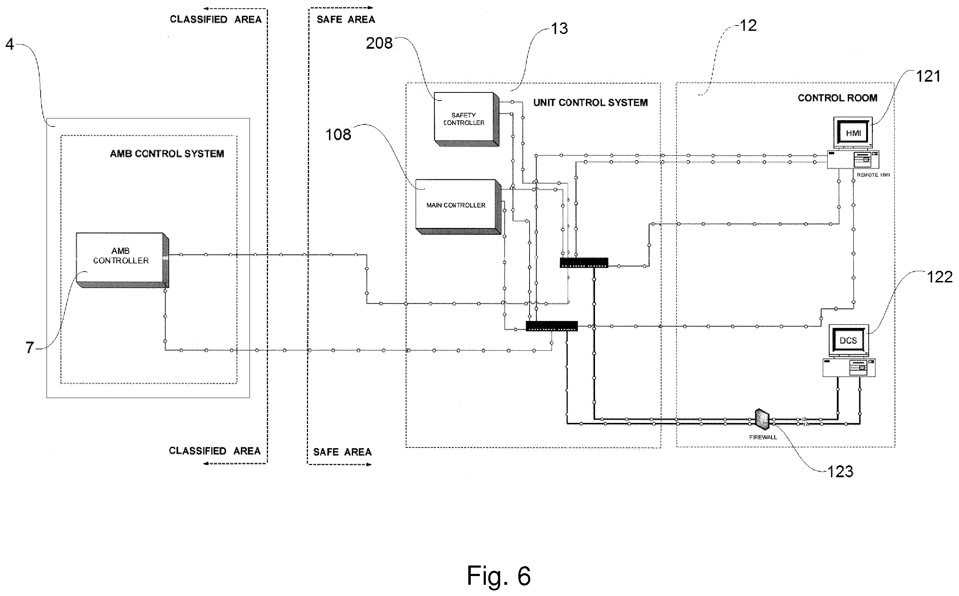

The user interface 121 (HMI) can be positioned in the unit control system area 13 or in a dedicated control room 12 in safe area connected to the unit control system 8 while the AMB control system 7 is installed in a control system compartment 4 comprising an explosion proof cabinet and located in hazardous area close to the machinery & auxiliary baseplate 11 as best shown in Fig. 6.

Remotely connected user interface 122 (DCS) through a firewall 123 preferably provided with redundant connection can be employed like in existing systems as well as emergency shut down system 124 (ESD) interfaced with the unit control system 8.

Since the electric and electronic components can be affected by the processed gas of the turbomachine, the control system compartment 4 is preferably pressurized and filled with air or an inert gas, for instance nitrogen. In the context of the present description and attached claims, the term inert gas also encompasses noble gases, such as helium, for instance, as well as gas mixtures, for instances mixtures mainly composed of nitrogen or helium.

In some embodiments, the control system compartment 4 comprises a pressurized cabinet, for example an ATEX cabinet according to European Directive 2014/34/EU.

In some embodiments a connector flange can be provided on the casing of the turbomachine and on the control system compartment 4 for the passage of cables 5, 6 which connect the expander-compressor unit 1 to the control system compartment 4. Suitable passages, channels or protective sheaths 304 can in practice be used to protect and contain the wiring in order to prevent damages during assembling of the components of the expander-compressor unit and/or during operation thereof. In some embodiments, the cables pass through a protection system connecting the casing to the control system compartment 4.

Electric connection between the electronic components of the control system compartment and the magnetic bearings can be obtained, for example, by means of pairs of electric connectors 101-204, 201-104 arranged on a surface of the casing and on a surface of the cabinet of the control system compartment 4.

In some embodiments, the control system compartment 4 comprises an explosion proof cabinet, for example an ATEX cabinet according to European Directive 2014/34/EU.

The cables connecting the control system compartment 4 with the casing of the turbomachine 1 typically comprise power cables 5 and signal cables 6. The power cables 5 connect the control system compartment 4 with the coils of the active magnetic bearings to control the current flowing thereto, while the signal cables 6 connect the control system with sensors 9 located in the casing. Such sensors may, for example, comprise position sensors, radial and/or axial, to monitor the position of the rotor, temperature sensors, vibration sensors, shaft speed sensors, accelerometers.

In an embodiment each active magnetic bearing comprises at least two coils, typically four coils per radial bearing, two coils per axial bearing, each driven by a couple of power cables.

Embodiments have been mainly illustrated with reference to an expander-compressor unit, but the teaching of the present disclosure can be used for any type of turbomachine having magnetic bearing, such as, for example, expander-generator, motor-compressor, motor, generator, turbo-generator units.

The description of exemplary embodiments refer to the accompanying drawings. The same reference numbers in different drawings identify the same or similar elements. The detailed description does not limit the invention. Instead, the invention is defined by the appended claims.

Reference throughout the specification to "one embodiment" or "an embodiment" means that a particular feature, structure, or characteristic described in connection with an embodiment is included in at least one embodiment of the subject matter disclosed. Thus, the appearance of the phrases "in one embodiment" or "in an embodiment" in various places throughout the specification is not necessarily referring to the same embodiment. Further, the particular features, structures or characteristics may be combined in any suitable manner in one or more embodiments.

## Claims

1. A turbomachine (1) comprising:
a casing;
a turbomachinery (2, 3) having a rotor mounted on a shaft (15) supported for rotation in the casing and comprising a unit control system (8) for the control of the turbomachinery (2, 3);
a plurality of active magnetic bearings (14) configured and arranged for supporting the shaft (15) in the casing;
an active magnetic bearing control system (7) for controlling the magnetic bearing (14) through a plurality of cables (5,6);
**characterized in that** the active magnetic bearing control system (7) and the unit control system (8) are housed in a control system compartment (4) external to the casing and located at a distance in proximity thereto;
wherein a connector flange is provided on the casing and on the control system compartment (4) for the passage of the cables (5, 6) which connect the turbomachine (1) to the control system compartment (4); and
wherein the cables comprise power cables (5) and signal cables (6), the power cables (5) connecting the control system compartment (4) with the coils of the magnetic bearings (14) to control the current flowing thereto, the signal cables (6) connecting the control system compartment (4) with sensors in the casing, such sensors comprising position sensors to monitor the position of the rotor.

2. Turbomachine according to claim 1, wherein the control system compartment (4) is pressurized.

3. Turbomachine according to claim 2, wherein the control system compartment (4) is pressurized with are or with an inert gas.

4. Turbomachine according to claim 3, wherein the inert gas is chosen in the group comprising nitrogen, helium and gas mixtures mainly comprised of nitrogen or helium.

5. Turbomachine according to one or more of claims from 1 to 4, wherein the control system compartment (4) comprises an explosion proof cabinet.

6. Turbomachine according to any preceding claim, wherein the power cables (5) are at least two for each coil, each magnetic bearing comprising at least two coils, typically four coils per radial bearing, two coils per axial bearing.

7. Turbomachine according to any preceding claim, wherein the signal cables (6) are two, four, or eight cables for each sensor, the sensors comprising one or more sensors selected from the group comprising axial position sensors, radial position sensors, shaft speed sensors, vibration sensors, temperature sensors.

8. Turbomachine according to any preceding claim, wherein the turbomachinery (2, 3) comprises:
a turboexpander or motor (2) having a rotor mounted on a shaft (15) supported for rotation in the casing;
a compressor (3) arranged in the casing and comprised of a rotor mounted on the shaft for co-rotation with turboexpander/motor rotor.

9. Turbomachine according to any preceding claim, further comprising a user interface (121) connected with the unit control system (8) and positioned in a remote control room (12) located in a safe area far away from the turbomachinery (2, 3).

10. Turbomachine according to one or more of the preceding claims, wherein the unit control system (8) comprises a main controller (108) and a safety controller (208), the main controller (108) implementing main controls of the machinery chosen in the group comprising start/stop sequence inclusive of auxiliaries, antisurge control, performance control, load sharing control, while the safety controller (208) performs safety functions like trip logics.

## Patentansprüche

1. Turbomaschine (1), umfassend:
ein Gehäuse;
eine Turbomaschine (2, 3) mit einem auf einer Welle (15) montierten Rotor, die zur Drehung in dem Gehäuse gelagert ist und ein Einheitssteuersystem (8) zum Steuern der Turbomaschine (2, 3) umfasst;
eine Vielzahl von aktiven Magnetlagern (14), die zum Tragen der Welle (15) in dem Gehäuse konfiguriert und angeordnet ist;
ein aktives Magnetlagersteuersystem (7) zum Steuern des Magnetlagers (14) über eine Vielzahl von Kabeln (5,6);
**dadurch gekennzeichnet, dass** das aktive Magnetlagersteuersystem (7) und das Einheitssteuersystem (8) in einer Steuersystemkammer (4) untergebracht sind, die sich außerhalb des Gehäuses befindet und in dessen Nähe angeordnet ist;
wobei ein Verbindungsflansch an dem Gehäuse und an der Steuersystemkammer (4) für den Durchgang der Kabel (5, 6) bereitgestellt ist, die die Turbomaschine (1) mit der Steuersystemkammer (4) verbinden; und
wobei die Kabel Stromkabel (5) und Signalkabel (6) umfassen, wobei die Stromkabel (5) die Steuersystemkammer (4) mit den Spulen der Magnetlager (14) verbinden, um den dorthin fließenden Strom zu steuern, wobei die Signalkabel (6) die Steuersystemkammer (4) mit Sensoren in dem Gehäuse verbinden, wobei solche Sensoren Positionssensoren umfassen, um die Position des Rotors zu überwachen.

2. Turbomaschine nach Anspruch 1, wobei die Steuersystemkammer (4) druckbeaufschlagt ist.

3. Turbomaschine nach Anspruch 2, wobei die Steuersystemkammer (4) mit Luft oder mit einem Inertgas druckbeaufschlagt wird.

4. Turbomaschine nach Anspruch 3, wobei das Inertgas aus der Gruppe ausgewählt wird, die Stickstoff, Helium und Gasmischungen umfasst, die hauptsächlich aus Stickstoff oder Helium bestehen.

5. Turbomaschine nach einem oder mehreren der Ansprüche 1 bis 4, wobei die Steuerungssystemkammer (4) einen explosionsgeschützten Schrank umfasst.

6. Turbomaschine nach einem der vorstehenden Ansprüche, wobei die Stromkabel (5) mindestens zwei für jede Spule sind, wobei jedes Magnetlager mindestens zwei Spulen umfasst, typischerweise vier Spulen pro Radiallager, zwei Spulen pro Axiallager.

7. Turbomaschine nach einem der vorstehenden Ansprüche, wobei die Signalkabel (6) zwei, vier oder acht Kabel für jeden Sensor sind, wobei die Sensoren einen oder mehrere Sensoren umfassen, die ausgewählt sind aus der Gruppe umfassend axiale Positionssensoren, radiale Positionssensoren, Wellendrehzahlsensoren, Vibrationssensoren, Temperatursensoren.

8. Turbomaschine nach einem der vorstehenden Ansprüche, wobei die Turbomaschine (2, 3) umfasst:
einen Turboexpander oder Motor (2), der einen Rotor, der an einer Welle (15) montiert ist, die für eine Drehung in dem Gehäuse getragen wird, aufweist;
einen Kompressor (3), der in dem Gehäuse angeordnet ist und aus einem Rotor besteht, der an der Welle zur gemeinsamen Drehung mit dem Turboexpander/Motorrotor montiert ist.

9. Turbomaschine nach einem der vorstehenden Ansprüche, ferner umfassend eine Benutzerschnittstelle (121), die mit dem Einheitssteuersystem (8) verbunden und in einem entfernten Steuerraum (12) positioniert ist, der sich in einem sicheren Bereich weit entfernt von der Turbomaschinenanlage (2, 3) befindet.

10. Turbomaschine nach einem oder mehreren der vorstehenden Ansprüche, wobei das Einheitssteuerungssystem (8) eine Hauptsteuerung (108) und eine Sicherheitssteuerung (208) umfasst, wobei die Hauptsteuerung (108) Hauptsteuerungen der Maschinen implementiert, die aus der Gruppe ausgewählt sind, die Start-/Stopp-Sequenz einschließlich Hilfssystemen, Pumpgrenzregelung, Leistungsregelung, Lastverteilungsregelung umfasst, während die Sicherheitssteuerung (208) Sicherheitsfunktionen wie Abschaltlogiken ausführt.

## Revendications

1. Turbomachine (1) comprenant :
un carter ;
un mécanisme de turbomachine (2, 3) ayant un rotor monté sur un arbre (15) supporté pour une rotation dans le carter et comprenant un système de commande d'unité (8) pour la commande du mécanisme de turbomachine (2, 3) ;
une pluralité de paliers magnétiques (14) actifs conçus et agencés pour supporter l'arbre (15) dans le carter ;
un système de commande de palier magnétique actif (7) permettant de commander le palier magnétique (14) par le biais d'une pluralité de câbles (5,6) ;
**caractérisé en ce que** le système de commande de palier magnétique actif (7) et le système de commande d'unité (8) sont logés dans un compartiment de système de commande (4) externe au carter et localisé à une distance à proximité de celui-ci ;
dans laquelle une bride de connecteur est fournie sur le carter et sur le compartiment de système de commande (4) pour le passage des câbles (5, 6) qui connectent la turbomachine (1) au compartiment de système de commande (4) ; et
dans laquelle les câbles comprennent des câbles de puissance (5) et des câbles de signal (6), les câbles de puissance (5) connectant le compartiment de système de commande (4) aux bobines des paliers magnétiques (14) pour commander le courant circulant vers celles-ci, les câbles de signal (6) connectant le compartiment de système de commande (4) à des capteurs dans le carter, de tels capteurs comprenant des capteurs de position pour surveiller la position du rotor.

2. Turbomachine selon la revendication 1, dans laquelle le compartiment de système de commande (4) est sous pression.

3. Turbomachine selon la revendication 2, dans laquelle le compartiment de système de commande (4) est sous pression avec de l'air ou avec un gaz inerte.

4. Turbomachine selon la revendication 3, dans laquelle le gaz inerte est choisi dans le groupe comprenant azote, hélium et des mélanges gazeux constitués principalement d'azote ou d'hélium.

5. Turbomachine selon l'une ou plusieurs des revendications allant de 1 à 4, dans laquelle le compartiment de système de commande (4) comprend une armoire antidéflagrante.

6. Turbomachine selon l'une quelconque revendication précédente, dans laquelle les câbles de puissance (5) sont au moins deux pour chaque bobine, chaque palier magnétique comprenant au moins deux bobines, typiquement quatre bobines par palier radial, deux bobines par palier axial.

7. Turbomachine selon l'une quelconque revendication précédente, dans laquelle les câbles de signal (6) sont deux, quatre, ou huit câbles pour chaque capteur, les capteurs comprenant un ou plusieurs capteurs choisis dans le groupe comprenant capteurs de position axiale, capteurs de position radiale, capteurs de vitesse d'arbre, capteurs de vibration, capteurs de température.

8. Turbomachine selon l'une quelconque revendication précédente, dans laquelle le mécanisme de turbomachine (2, 3) comprend :
un turbodétendeur ou un moteur (2) ayant un rotor monté sur un arbre (15) supporté pour une rotation dans le carter ;
un compresseur (3) agencé dans le carter et constitué d'un rotor monté sur l'arbre pour une rotation conjointe avec le rotor de turbodétendeur/moteur.

9. Turbomachine selon l'une quelconque revendication précédente, comprenant en outre une interface utilisateur (121) connectée au système de commande d'unité (8) et positionnée dans un local de commande à distance (12) situé dans une zone sûre éloignée du mécanisme de turbomachine (2, 3).

10. Turbomachine selon l'une ou plusieurs des revendications précédentes, dans laquelle le système de commande d'unité (8) comprend un dispositif de commande principal (108) et un dispositif de commande de sécurité (208), le dispositif de commande principal (108) implémentant des commandes principales du mécanisme, choisies dans le groupe comprenant séquence de démarrage/arrêt y compris des composants auxiliaires, commande antisurcharge, commande de performance, commande de répartition de charge, alors que le dispositif de commande de sécurité (208) met en œuvre des fonctions de sécurité de type logiques de déclenchement.
